# DEMANDE DE BREVET EUROPEEN

(11) **EP 3 840 032 A1**
(43) Date de publication de la demande: **23.06.2021**
(21) Numéro de dépôt: 20214512.4
(22) Date de dépôt: 16.12.2020
(51) Int. Cl.: H01L 21/762, H01L 21/265, H01L 21/304, H01L 21/322

(54) **PROCÉDÉ D'ÉLABORATION D'UN EMPILEMENT MULTICOUCHE DE TYPE SEMI-CONDUCTEUR-SUR-ISOLANT**

(30) Priorité: 19.12.2019 FR 1915019
(71) Demandeur: Commissariat à l'Energie Atomique et aux Energies Alternatives, 75015 Paris (FR)
(72) Inventeur: REBOH, Shay, 38054 GRENOBLE CEDEX 09 (FR); ACOSTA ALBA, Pablo, 38054 GRENOBLE CEDEX 09 (FR)
(74) Mandataire: Decobert, Jean-Pascal

(57) **Abrégé**

L'invention concerne un empilement multicouche de type semi-conducteur-sur-isolant et le procédé d'élaboration associé, le procédé comprenant l'implantation d'ions dans une portion enterrée d'une couche superficielle (10) d'un substrat support, de façon à former une couche enrichie en au moins un gaz, destinée à former une couche de matériau semi-conducteur poreux (11'), l'oxydation thermique d'une portion superficielle de la couche superficielle (10) pour former une couche d'oxyde (12') s'étendant à partir de la surface du substrat support (1), l'oxydation et l'implantation d'ions étant configurées de sorte que la couche d'oxyde (12') et la couche enrichie soient juxtaposées, et l'assemblage du substrat support (1) et d'un substrat donneur (2).

## Description

### DOMAINE TECHNIQUE

La présente invention concerne le domaine des empilements multicouches de type semi-conducteur-sur-isolant et leur procédé d'élaboration. D'une manière générale, le domaine des dispositifs micro-électroniques est visé. Par dispositif microélectronique, on entend tout type de dispositif réalisé avec les moyens de la microélectronique. Ces dispositifs englobent notamment, en plus des dispositifs à finalité purement électronique, des dispositifs micromécaniques ou électromécaniques (MEMS, de l'anglais microelectromechanical systems que l'on peut traduire par systèmes microélectromécaniques, NEMS, de l'anglais nanoelectromechanical systems que l'on peut traduire par systèmes nanoélectromécaniques,...) ainsi que des dispositifs optiques ou optoélectroniques (MOEMS, de l'anglais Micro-Opto-Electro-Mechanical System que l'on peut traduire par microsystèmes opto-électro-mécaniques,...). Elle trouve pour application particulièrement avantageuse le domaine des modules radiofréquence (abrégé RF dans la suite), et notamment des modules frontaux (aussi appelés modules *front-end* en anglais).

### ÉTAT DE LA TECHNIQUE

Les modules radiofréquences sont des éléments critiques pour la bonne opération des systèmes cellulaires et Wi-Fi. Par exemple, parmi ces modules, les modules RF frontaux agissent comme interface entre une antenne et un émetteur-récepteur RF. Un module RF frontal comprend, de façon générale, des composants sensibles tels qu'un amplificateur à faible bruit du signal reçu par l'antenne, des amplificateurs de puissance, des interrupteurs pour le réglage de l'antenne et une unité de gestion de la puissance.

L'élaboration de ces modules présente de nombreux défis de conception, tels que l'isolation des interrupteurs linéaires et la maximisation de l'efficacité des amplificateurs de puissance. Selon l'approche conventionnelle d'élaboration de ces modules, des procédés spécifiques ont été développés pour chaque partie du module RF frontal, conduisant à de multiples composants distincts et de multiples circuits intégrés.

En parallèle, de nouvelles technologies hautes vitesses se développent dans les systèmes cellulaires et Wi-Fi. Aujourd'hui, les systèmes cellulaires 4G et 5G deviennent des standards de haute vitesse, et utilisent jusqu'à quarante bandes de fréquences différentes pour augmenter la quantité de données échangées. Il s'agit donc de complexifier ces systèmes, et notamment d'incorporer des modules RF frontaux supplémentaires, ce qui entraine une augmentation significative de la taille des systèmes lorsqu'on suit l'approche conventionnelle.

L'augmentation croissante de la complexité de ces systèmes demande donc de développer de nouveaux procédés pour obtenir des empilements multicouches permettant une plus grande flexibilité et une meilleure intégration dans l'élaboration des modules RF, et notamment des modules RF frontaux, sans détériorer la performance obtenue. Dans ce contexte, l'utilisation d'empilement multicouches de type silicium-sur-isolant (abrégé SOI, de l'anglais *Silicon-On-Insulator*), pour des technologies désignées RF-SOI, répond aux exigences techniques et aux performances voulues, tout en permettant un haut niveau d'intégration.

Aujourd'hui, des procédés d'élaboration d'empilement multicouches de type SOI, notamment pour des technologies RF-SOI, reposent essentiellement sur le dépôt de silicium polycristallin (aussi désigné Poly-Si) en surface d'un substrat support suivi d'un procédé communément appelé Smart-Cut®. Dans ce procédé, le substrat support et un substrat donneur sont assemblés par l'intermédiaire d'une couche d'oxyde de silicium disposée soit sur le substrat support soit sur le substrat donneur, soit sur les deux.

Ce procédé nécessite généralement un traitement de la surface de la couche Poly-Si afin de diminuer sa rugosité, et ainsi favoriser le collage du substrat donneur et du substrat support. Typiquement, on cherche à obtenir une rugosité moyenne quadratique inférieure à 1 nm. Ceci peut être effectué par un polissage chimique et/ou mécanique. Cela augmente toutefois le coût et la complexité du procédé.

En outre, lors d'une oxydation du silicium polycristallin, différents taux d'oxydation peuvent être créés entre des grains de silicium ayant des orientations et des tailles différentes, diminuant ainsi l'homogénéité de la couche. Les joints de grains peuvent induire des inhomogénéités et des variations de l'épaisseur de la couche d'oxyde de silicium formée. Notamment, cela peut perturber des mesures d'épaisseur sur l'empilement multicouche. La qualité, voire l'épaisseur d'oxyde de silicium formée est donc limitée, ce qui peut restreindre les applications de l'empilement multicouches de type SOI, et notamment pour certaines applications RF-SOI.

En alternative à l'oxydation du silicium polycristallin, il est possible de déposer une couche épaisse d'oxyde de silicium sur la couche de silicium polycristallin. Toutefois, les propriétés isolantes de cette couche sont limitées.

Un objet de la présente invention est donc de proposer un procédé de fabrication d'un empilement multicouches de type semi-conducteur-sur isolant, par exemple de type SOI, et en particulier pour des technologies RF-SOI, dont les propriétés sont améliorées. Un objectif non limitatif de l'invention peut être de proposer un nouveau type de couche de piégeage adaptée à l'application RF, tout en facilitant la fabrication d'un substrat de type semi-conducteur-sur isolant, par exemple de type SOI, et en particulier pour des technologies RF-SOI comprenant cette couche de piégeage. Un autre objectif de l'invention est de proposer un empilement multicouches de type SOI, dont les propriétés sont améliorées. Un objectif non limitatif de l'invention peut être d'améliorer la qualité de la surface de collage entre le substrat support et le substrat donneur. Un autre objectif non limitatif de l'invention peut être d'améliorer la qualité, voire d'autoriser un agrandissement de l'épaisseur de la couche d'oxyde.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ

Pour atteindre cet objectif, selon un mode de réalisation on prévoit un procédé d'élaboration d'un empilement multicouches de type semi-conducteur-sur-isolant, le procédé comprenant :
- une fourniture d'un substrat support, le substrat support comprenant une couche superficielle à base d'un matériau semi-conducteur monocristallin, puis
- une implantation d'ions choisis parmi des ions de gaz noble et d'hydrogène dans une portion enterrée de la couche superficielle du substrat support, à une profondeur de la surface de la couche superficielle, de façon à former une couche enrichie en au moins un gaz, formée à partir desdits ions, dans ladite portion enterrée, ladite couche enrichie en au moins un gaz étant destinée à former une couche de matériau semi-conducteur poreux,
- une oxydation thermique d'une portion au moins superficielle de la couche superficielle du substrat support, pour former une couche d'oxyde s'étendant à partir de la surface de la couche superficielle du substrat support, l'oxydation et l'implantation d'ions étant configurées de sorte que la couche d'oxyde et la couche enrichie en au moins un gaz soient juxtaposées,
- une fourniture d'un substrat donneur, le substrat donneur comprenant une couche superficielle donneuse, présentant une surface, puis
- un assemblage du substrat support et du substrat donneur.

La couche de matériau semi-conducteur (qui peut être du silicium) poreux étant obtenue par implantation d'ions, il est possible d'obtenir une couche de matériau semi-conducteur poreux de façon localisée dans la couche superficielle du substrat support, au moins dans la profondeur de la couche. Le procédé permet d'obtenir un empilement de type semi-conducteur-sur isolant, par exemple de type SOI, contenant une couche de matériau semi-conducteur poreux juxtaposée à une couche d'oxyde enterrée dans l'empilement. Ainsi, la couche d'un matériau semi-conducteur poreux forme une couche de piégeage de charge, pouvant être désignée par l'expression *« trap-rich layer* » en anglais, permettant d'améliorer les performances de l'empilement multicouches de type SOI, en particulier pour des technologies RF-SOI. En outre, selon les paramètres de l'implantation d'ions, et notamment selon la nature chimique des ions et l'énergie d'implantation, la profondeur d'implantation dans la couche superficielle du substrat support peut être ajustée. La couche d'oxyde et la couche de matériau semi-conducteur poreux étant juxtaposées, et la couche d'oxyde s'étendant à partir de la surface de la couche superficielle du substrat support, on comprend que l'épaisseur de la couche d'oxyde enterrée peut être modulée.

Par ailleurs, la couche d'oxyde enterrée est obtenue par oxydation thermique du matériau semi-conducteur monocristallin. La couche d'oxyde en surface du substrat support présente ainsi une rugosité suffisamment faible pour ne pas avoir à effectuer de polissage mécanique et/ou chimique de la couche d'oxyde, préalablement à l'assemblage du substrat support et du substrat donneur. Le procédé d'élaboration de l'empilement multicouche est ainsi facilité. La qualité de l'interface créée par collage entre le substrat support et le substrat donneur est en outre améliorée.

Avantageusement, l'implantation d'ions dans la portion enterrée de la couche superficielle du substrat support, peut précéder l'oxydation thermique de la portion superficielle de la couche superficielle du substrat support. Ainsi, une éventuelle perturbation de l'implantation des ions dans la portion enterrée, par la couche d'oxyde est évitée. L'implantation des ions à une profondeur importante du substrat support est alors facilitée. Une couche d'oxyde enterrée obtenue, par oxydation thermique, plus épaisse que dans l'état de la technique peut ainsi être obtenue. En outre, en effectuant l'oxydation thermique après l'implantation d'ions, le risque d'une éventuelle détérioration de la couche d'oxyde par l'implantation d'ions dans la portion enterrée, est minimisé, voire évité. Cela permet d'éviter la création de défauts dans l'oxyde, notamment la création de porteurs de charges qui pourraient réduire les performances de l'empilement. En outre, en effectuant l'oxydation thermique après l'implantation d'ions et la formation de la couche poreuse, il est possible de transformer par oxydation au moins une portion de la couche poreuse.

Selon un exemple, la couche d'oxyde de la couche superficielle du substrat support peut être destinée à former au moins une surface d'assemblage lors de l'assemblage du substrat support et du substrat donneur.

Selon un exemple, le substrat support et le substrat donneur sont assemblés de façon à adjoindre la surface du substrat support à la surface du substrat donneur, et plus particulièrement la surface de leur couche superficielle respective.

Selon un exemple, le matériau semi-conducteur peut être choisi parmi le silicium, ou des alliages de silicium semi-conducteurs tels que le carbure de silicium de formule SiC et un alliage de silicium-germanium de formule Si-Ge. Selon un exemple plus particulier, le matériau semi-conducteur à base de silicium.

De préférence, le substrat donneur comprend une couche superficielle donneuse à base de matériau semi-conducteur monocristallin. En outre, le procédé peut comprendre une formation d'une zone de fragilisation à une profondeur de la surface de la couche superficielle donneuse du substrat donneur, puis une séparation du substrat donneur au niveau de la zone de fragilisation.

Selon un aspect séparable ou complémentaire, on prévoit un procédé d'élaboration d'un empilement multicouches de type semi-conducteur-sur-isolant, le procédé comprenant :
- une fourniture d'un substrat support, le substrat support comprenant une couche superficielle à base d'un matériau semi-conducteur monocristallin, puis
- une implantation d'ions choisis parmi des ions de gaz noble et d'hydrogène dans une portion enterrée de la couche superficielle du substrat support, à une profondeur de la surface de la couche superficielle, de façon à former une couche enrichie en au moins un gaz, formée à partir desdits ions, dans ladite portion enterrée, ladite couche enrichie en au moins un gaz étant destinée à former une couche de matériau semi-conducteur poreux,
- une fourniture d'un substrat donneur, le substrat donneur comprenant une couche superficielle donneuse, comprenant une couche d'oxyde,
- un assemblage du substrat support et du substrat donneur.

La couche d'oxyde ne perturbe donc pas l'implantation des ions dans le substrat support, et le risque d'une éventuelle détérioration de la couche d'oxyde par l'implantation d'ions dans la portion enterrée, est évité. En outre, l'épaisseur de la couche d'oxyde sur le substrat donneur n'est ainsi pas limitée par la formation la couche de matériau semi-conducteur poreux.

De préférence, l'assemblage du substrat support est effectué après l'implantation d'ions. Le procédé peut être configuré de sorte que la couche d'oxyde du substrat donneur et la couche enrichie en au moins un gaz soient juxtaposées.

Selon un exemple, la couche d'oxyde peut s'étendre jusqu'à la surface de la couche superficielle donneuse du substrat donneur. L'implantation d'ions et l'assemblage, voire au moins une étape du procédé préalable à l'assemblage, sont de préférence configurés de sorte que la couche d'oxyde du substrat donneur et la couche enrichie en au moins un gaz soient juxtaposées.

Selon un aspect séparable ou complémentaire, on prévoit un procédé d'élaboration d'un empilement multicouches de type semi-conducteur-sur-isolant, le procédé comprenant:
- une fourniture d'un substrat support, le substrat support comprenant une couche superficielle à base d'un matériau semi-conducteur monocristallin,
- une implantation d'ions choisis parmi des ions de gaz noble et d'hydrogène dans une portion enterrée de la couche superficielle du substrat support, à une profondeur P1 de la surface de la couche superficielle, de façon à former une couche enrichie en au moins un gaz, formée à partir desdits ions, dans ladite portion enterrée, ladite couche enrichie en au moins un gaz étant destinée à former une couche de matériau semi-conducteur poreux,
- une fourniture d'un substrat donneur, le substrat donneur comprenant une couche superficielle donneuse, présentant une surface,
- une oxydation thermique d'une portion au moins superficielle de la couche superficielle de l'un parmi le substrat support et le substrat donneur, pour former une couche d'oxyde s'étendant à partir de la surface de la couche superficielle,
- un assemblage du substrat support et du substrat donneur.

Selon un deuxième aspect, l'invention concerne un empilement multicouche de type semi-conducteur-sur-isolant, l'empilement multicouche comprenant :
- un substrat support comprenant une première couche à base d'un matériau semi-conducteur monocristallin,
- une couche d'oxyde de matériau semi-conducteur enterrée,
- une deuxième couche à base de matériau semi-conducteur monocristallin, juxtaposée à la couche d'oxyde.

De manière avantageuse, l'empilement multicouche comprend une couche de matériau semi-conducteur poreux, juxtaposée entre la première couche à base de matériau semi-conducteur monocristallin et la couche d'oxyde.

De préférence, la deuxième couche de matériau semi-conducteur monocristallin est située en surface de l'empilement multicouche.

L'empilement multicouche selon cet aspect de l'invention peut notamment être obtenu par le procédé selon le premier aspect et/ou selon l'un des aspects de l'invention. L'empilement de type SOI contient une couche de matériau semi-conducteur poreux juxtaposée à une couche d'oxyde enterrée dans l'empilement.

Selon un troisième aspect, l'invention concerne un module radiofréquence comprenant un empilement multicouche selon le deuxième aspect de l'invention.

### BRÈVE DESCRIPTION DES FIGURES

Les buts, objets, ainsi que les caractéristiques et avantages des différents aspects de l'invention ressortiront mieux de la description détaillée de modes de réalisation de ces différents aspects, illustrés par les dessins d'accompagnement suivants.
La figure 1 représente une vue schématique et selon une section transversale de la couche superficielle d'un substrat support mis en œuvre dans le procédé selon un mode de réalisation.
Les figures 1A à 1C illustrent l'implantation d'ions, selon plusieurs modes de réalisation du procédé selon l'invention, dans une portion de la couche superficielle du substrat support illustré en figure 1.
Les figures 2A et 2B représentent le substrat support obtenu après un recuit thermique, selon un mode de réalisation du procédé selon l'invention, effectué sur la couche superficielle illustrée par chacune des figures 1A et 1B.
La figure 3 représente une croissance épitaxiale de silicium sur la couche superficielle illustrée en figure 2A, selon un mode de réalisation du procédé selon l'invention.
La figure 4 illustre l'oxydation de la couche superficielle du substrat support illustré en figure 1, selon un mode de réalisation du procédé selon l'invention.
La figure 5 illustre l'implantation d'ions dans une portion de la couche superficielle du substrat support illustré en figure 4, selon un mode de réalisation du procédé selon l'invention.
Les figures 6A et 6B représentent la couche superficielle du substrat support obtenue après l'implantation d'ions, le recuit thermique et l'oxydation thermique, selon deux modes de réalisation du procédé selon l'invention.
La figure 7 représente la couche superficielle du substrat support obtenue après une gravure de la couche d'oxyde, de la couche superficielle illustrée en figure 6A, selon un mode de réalisation du procédé selon l'invention.
La figure 8 représente une vue schématique et selon une section transversale de la couche superficielle d'un substrat donneur mis en œuvre dans le procédé selon un mode de réalisation.
La figure 9 illustre l'oxydation de la couche superficielle du substrat donneur illustré en figure 8, selon un mode de réalisation du procédé selon l'invention.
Les figures 10A et 10B illustrent l'implantation d'ions, selon plusieurs modes de réalisation du procédé selon l'invention, dans chacune des portions de la couche superficielle du substrat support illustrées en figure 8 et 9.
Les figures 11A et 11B représentent l'assemblage formé par la couche superficielle du substrat support et la couche superficielle du substrat donneur, selon deux modes de réalisation du procédé selon l'invention.
Les figures 12A et 12B représentent l'assemblage obtenu par la séparation du substrat donneur, à partir de chacun des assemblages illustrés en figure 11A et 11B, selon un mode de réalisation du procédé selon l'invention.
Les figures 13A à 13C représentent l'empilement multicouche selon plusieurs modes de réalisation de l'invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs et les dimensions relatives de substrat, de couche, de zone ou des portions illustrés ne sont pas représentatifs de la réalité.

### DESCRIPTION DÉTAILLÉE

Avant d'entamer une revue détaillée de modes de réalisation de l'invention, sont énoncées ci-après des caractéristiques optionnelles du procédé selon le premier aspect et/ou selon l'un des aspects de l'invention qui peuvent éventuellement être utilisées en association ou alternativement :
- l'implantation d'ions dans la portion enterrée de la couche superficielle du substrat support, est réalisée à travers une portion non oxydée de la couche superficielle du substrat support. La couche d'oxyde ne perturbe ainsi pas l'implantation des ions dans le substrat support, et le risque d'une éventuelle détérioration de la couche d'oxyde par l'implantation d'ions dans la portion enterrée, est minimisé, voire évité. De préférence, l'oxydation thermique peut être effectuée sur le substrat donneur, et/ou sur le substrat support à la suite de l'implantation d'ions,
- l'oxydation thermique formant la couche d'oxyde forme une interface de juxtaposition avec la couche enrichie en au moins un gaz, dans laquelle au moins une partie de la couche enrichie en au moins un gaz est oxydée. Ainsi, une portion de la couche poreuse à l'interface avec la couche d'oxyde peut être au moins en partie oxydée au niveau de cette interface,
- l'interface de juxtaposition présente une épaisseur sensiblement comprise entre 3 nm et 100 nm,
- le procédé peut être exempt d'un polissage de la surface d'au moins une parmi la couche superficielle du substrat support et la couche superficielle donneuse du substrat donneur, préalablement à l'assemblage du substrat support et du substrat donneur,
- le procédé peut en outre comprendre, entre l'implantation d'ions dans la portion enterrée de la couche superficielle du substrat support et l'oxydation thermique de la portion superficielle de la couche superficielle du substrat support, une croissance épitaxiale d'une couche de matériau semi-conducteur sur la surface de la couche superficielle du substrat support,
- l'implantation d'ions dans la portion enterrée de la couche superficielle du substrat support, peut suivre l'oxydation thermique de la portion superficielle de la couche superficielle du substrat support et précéder l'assemblage du substrat support et du substrat donneur,
- le procédé peut en outre comprendre un recuit thermique du substrat support à la suite de l'implantation d'ions dans la portion enterrée de la couche superficielle du substrat support. Dans un mode de réalisation particulier, le recuit thermique est effectué entre l'implantation d'ions et l'oxydation thermique,
- le recuit thermique peut comprendre un recuit d'exodiffusion pour évacuer l'au moins un gaz de ladite couche enrichie,
- l'implantation d'ions dans la portion enterrée de la couche superficielle du substrat support peut être effectuée à une énergie d'implantation comprise entre 0,5 keV et 1 MeV, de préférence entre 1 keV et 200 keV,
- le procédé peut comprendre plusieurs implantations d'ions, de préférences successives.
- lorsque le procédé comprend plusieurs implantations d'ions, les éléments chimiques des ions et/ou les proportions relatives entre des ions d'éléments chimiques distincts varient entre les différentes implantations d'ions. Ainsi, les ions implantés peuvent être des ions d'éléments chimiques différents. Par exemple, des ions d'hydrogène sont implantés dans une implantation, et des ions d'hélium sont implantés dans une autre implantation. Dans le cas de l'implantation d'un mélange d'ions, les proportions relatives entre les différents ions du mélange peuvent varier entre plusieurs implantations. De façon alternative ou complémentaire, dans au moins une implantation, un seul type d'ion peut être implanté, et dans au moins une autre implantation, un mélange d'ions peut être implanté. De façon alternative ou complémentaire, plusieurs mélanges d'ions peuvent être implantés, les mélanges variant entre les différentes implantations, par exemple par les éléments chimiques des ions, voire leurs proportions relatives entre des ions d'éléments chimiques distincts,
- lorsque le procédé comprend plusieurs implantations d'ions, au moins une parmi les plusieurs implantations d'ions peut être réalisée à une profondeur d'implantation différente par rapport aux profondeurs d'implantation des autres implantations d'ions
- lorsque le procédé comprend plusieurs implantations d'ions, au moins une parmi les plusieurs implantations d'ions est configurée pour implanter une dose différente par rapport aux doses implantées des autres implantations d'ions.

Des caractéristiques optionnelles de l'empilement multicouches selon le deuxième aspect de l'invention sont énoncées ci-après, qui peuvent éventuellement être utilisées en association ou alternativement :
- la couche d'oxyde peut être d'une épaisseur comprise entre 20 nm et 3 µm, de préférence comprise entre 50 nm et 2 µm.
- la couche de matériau semi-conducteur poreux peut comprendre plusieurs sous-couches juxtaposées, au moins une parmi les sous-couches présentant des pores de diamètre différent des diamètres des pores des autres sous-couches.

Il est précisé que dans le cadre de la présente invention, le terme « sur », « surmonte », ou leurs équivalents ne signifient pas forcément « au contact de », sauf mention contraire de « juxtaposé ». Par des couches, ou portions, ou zones « juxtaposés » on entend ici que les couches, ou portions, ou zones sont en contact selon leur plan d'extension principale et disposées les unes au-dessus des autres selon la direction de l'empilement, cette direction étant perpendiculaire au plan d'extension principale. Par « en contact », on entend qu'une fine interface puisse exister, causée par la variabilité de fabrication. Dans le cadre de l'invention, cette interface est négligeable vis-à-vis de son effet induit, et notamment sur les propriétés électriques. Par conséquent, on considère malgré tout que ces couches, ou portions, ou zones, sont en contact. Par exemple, dans la disposition d'une première couche au contact d'une deuxième couche, une fine interface d'une épaisseur inférieure à 3 nm peut exister, plus particulièrement formée de matériau du substrat à l'état non oxydé.

Dans la description qui suit, les épaisseurs de couche, de zone ou de portion ainsi que les profondeurs sont généralement mesurées selon une direction verticale, parallèle à la direction d'empilement et perpendiculaire au plan principal d'extension du substrat, de la couche, de la sous-couche ou de la portion.

On entend par un substrat, une couche, une zone ou une portion « à base » d'un matériau A, un substrat, une couche, une zone ou une portion comprenant ce matériau A, par exemple à hauteur d'au moins 50%,et éventuellement d'autres matériaux, par exemple des éléments dopants.

Par « couche enrichie » on comprend que la couche comprend comme élément supplémentaire l'au moins un gaz issu des ions implantés.

On entend par un paramètre « sensiblement égal/supérieur/inférieur à » une valeur donnée, que ce paramètre est égal/supérieur/inférieur à la valeur donnée, à plus ou moins 10 % près, voire à plus ou moins 5 % près, de cette valeur.

Par porosité d'une couche, d'une sous-couche, d'une zone ou d'une portion, on entend la proportion de vide ou de gaz dans la couche, la sous-couche, la zone ou la portion. Les pores peuvent être sous la forme de cavités et/ou de bulles. Par « cavité », on entend un volume vide. Par « bulles » on entend un volume rempli de gaz.

On entend par « collage direct » un collage sans apport de matière adhésive (de type colle ou polymère notamment) qui consiste en la mise en contact de surfaces relativement lisses (d'une rugosité typiquement inférieure à 5 Å, 10⁻⁹ m), par exemple réalisé à température ambiante et sous atmosphère ambiante, afin de créer une adhérence entre elles.

Selon un mode de réalisation, le collage direct de deux substrats signifie que le collage est obtenu par les liens chimiques qui s'établissent entre les deux surfaces mises en contact.

Le collage direct peut être obtenu sans nécessiter l'application d'une pression importante sur la structure à assembler. Une légère pression pourra simplement être appliquée pour initier le collage. Un recuit thermique peut en outre être effectué pour initier le collage.

Dans le cadre de l'invention, les énergies sont données en électronvolt, pour lequel 1 eV ≈ 1,602.10⁻¹⁹ J, dans le système international des unités.

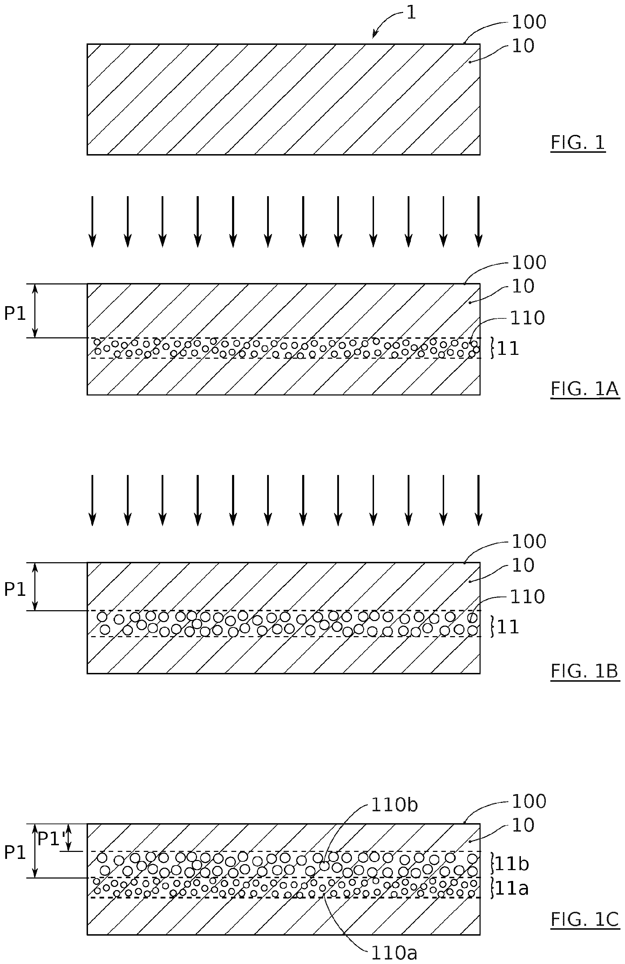

Le procédé d'élaboration d'un empilement multicouches de type silicium-sur-isolant (abrégé SOI dans la suite de la description), est maintenant décrit en référence aux figures 1 à 13A.

Le procédé comprend tout d'abord la fourniture d'un substrat support 1, comme illustré en figure 1. Ce substrat support 1 comprend une couche superficielle 10 à base de matériau semi-conducteur monocristallin. À titre d'exemple, le matériau semi-conducteur peut être choisi parmi le silicium, ou des alliages de silicium semi-conducteurs tels que le carbure de silicium de formule SiC et un alliage de silicium-germanium de formule Si-Ge. Dans la suite, on se réfère au cas où le matériau semi-conducteur est à base de silicium. Notons que sur les figures 1 à 7 et 11A à 12B, seule la couche superficielle 10 du substrat support 1 est représentée. Le substrat 1 peut néanmoins être sous la forme d'un empilement d'une pluralité de couches, par exemple à base de différents matériaux. La couche 10, est donc située en surface du substrat support 1 et présente une surface exposée 100. La couche 10 peut en outre être uniquement constituée de silicium monocristallin, en négligeant les impuretés liées à la l'élaboration du silicium. Le substrat support 1 peut par exemple être une plaquette, communément appelée wafer, de silicium.

L'implantation d'ions est décrite en référence aux figures 1A à 1C. L'implantation d'ions est mise en oeuvre sur le substrat 1 de façon à implanter des ions dans une portion 11 de la couche superficielle 10, de façon localisée selon une direction perpendiculaire à un plan principal d'extension de la couche 10. Ainsi, la portion implantée ne s'étend pas dans toute l'épaisseur de la couche superficielle 10 du substrat 1. Cette portion 11 s'étend plus particulièrement selon un des plans d'extension principal de la couche superficielle 10. L'implantation d'ions est telle que la portion 11 se situe à une profondeur P1 de la surface exposée 100 de la couche 10. La profondeur P1 est, par exemple, supérieure ou égale à 1 nm voire plus, de manière à ne pas modifier la surface 100. La portion 11 est donc enterrée par rapport à la surface 100 de la couche superficielle 10. La portion 11 sera donc désignée portion enterrée 11. Pour cela, la couche superficielle 10 est soumise à un flux d'ions à une énergie d'implantation donnée, et de façon à implanter une dose d'ions dans la couche superficielle 10.

L'implantation d'ions induit ainsi la formation d'une couche enrichie en au moins un gaz au niveau de la portion enterrée 11. Cette couche enrichie en gaz peut être sous la forme d'une microstructure de pores 110 permettant de former la couche poreuse, par exemple lorsque l'implantation d'ions est réalisée à une forte dose. En alternative, la couche enrichie en gaz peut ne pas être sous la forme d'une microstructure de pores 110 suite à l'étape d'implantation, notamment dans le cas où le gaz est diffus dans cette couche, par exemple lorsque l'implantation d'ions est réalisée à une plus faible dose. Les pores 110 pourront notamment être formés lors d'un recuit, décrit plus en détail ultérieurement. Dans la suite, on désigne le terme générique de microstructure 110 pour désigner ces différents aspects de la couche enrichie en gaz. Selon un exemple, au moins 70 %, et de préférence au moins 85 % voire 100 % des pores peuvent être isolés les uns des autres dans la microstructure 110 formées, pour augmenter la surface des pores dans la couche poreuse 11'.

La portion enterrée 11 est ainsi destinée à l'issue du procédé à former une couche de silicium poreux 11'. De préférence, la portion enterrée 11 s'étend sensiblement dans tout le plan principal d'extension de la couche 10, à la profondeur P1. Selon un mode de réalisation particulier, la portion enterrée 11 s'étend sensiblement dans tout le plan principal d'extension de la couche 10, et notamment de façon ininterrompue. Selon un autre mode de réalisation, le procédé peut comprendre l'application d'un masque sur une fraction d'une surface exposée du substrat support 1, préalablement à l'implantation d'ions, ainsi qu'un retrait du masque après l'implantation d'ions. Grâce à l'application d'un masque, l'implantation d'ions peut être réalisée dans au moins une fraction de la couche 10 selon un plan principal d'extension de cette couche. La portion poreuse formée dans la couche peut ainsi être fractionnée.

Selon des paramètres de l'implantation d'ions, les paramètres de la portion enterrée 11 ainsi que la microstructure 110 formée peuvent être modifiés. Pour cela, les principaux paramètres de l'implantation d'ions comprennent la nature des ions implantés, et notamment l'élément chimique des ions implantés, la température d'implantation et plus particulièrement la température du substrat 1 lors de l'implantation, le courant d'implantation, l'énergie d'implantation et la dose implantée. Par exemple, des outils de calculs d'arrêt et portée des ions dans la matière (pouvant être abrégé SRIM, de l'anglais *Stopping and Range of Ions in Matter)* peuvent être utilisés pour déterminer la pénétration des ions dans la matière.

L'implantation d'ions peut plus particulièrement être réalisée à une température comprise entre sensiblement -200 °C, correspondant à la température de l'azote liquide, et 1200 °C.

L'énergie d'implantation influe notamment sur la profondeur d'implantation de la couche enrichie en gaz. L'énergie d'implantation peut plus particulièrement être comprise entre 0,5 keV et 1 MeV, et de préférence entre 1 keV et 200 keV Dans cette gamme d'énergie, la profondeur P1 d'implantation d'ions peut être modulée.

La dose d'ions implantés peut être comprise entre 10¹⁴ et 10¹⁸ ions/cm², et de préférence entre 10¹⁶ et 5.10¹⁷ ions/cm². Une gamme de dose d'ions implantés comprise entre préférence entre 10¹⁶ et 5.10¹⁷ ions/cm² est particulièrement adaptée pour obtenir une couche de silicium poreux, notamment lorsque les ions implantés sont des ions d'hydrogène et/ou de gaz nobles, tels que l'hélium, le néon et l'argon. Notons que les paramètres d'implantations, et par exemple la dose, sont choisis de manière à limiter, voire éviter, l'exfoliation ou le clivage de la surface 100 du substrat support 1. Par exemple, une forte dose d'ions d'hydrogène peut provoquer une exfoliation superficielle lors du recuit décrit ultérieurement.

Selon un premier exemple illustré en figure 1A, des ions sont implantés dans la couche 10 par sa surface 100, comme représenté par les flèches. Il en résulte la portion enterrée 11, située à une profondeur P1. L'épaisseur de la portion enterrée 11 peut être modulée. Par exemple, l'épaisseur de la portion enterrée 11 peut être augmentée en augmentant la dose implantée ou en effectuant de multiples implantations à des énergies différentes.

Des ions de natures chimiques distinctes, et plus particulièrement d'éléments chimiques distincts, peuvent être implantés, voire un mélange d'ions de natures chimiques distinctes peut être implanté. Des ions de gaz, voire un mélange d'ions de gaz, sont implantés. Selon un exemple, des ions d'hydrogène et/ou de gaz noble, ou de façon équivalente de gaz rare, voire un mélange d'ions d'hydrogène et/ou de gaz noble, sont implantés. Les ions de gaz noble sont choisis parmi les ions de l'hélium, du néon, de l'argon, du krypton, du xénon et du radon. De préférence, des ions d'hélium, d'argon, de néon, de xénon, ou leur mélange peuvent être implantés.

En fonction de la nature du gaz, la microstructure 110 peut être modifiée. Le procédé permet par conséquent d'ajuster la porosité de la couche de semi-conducteur dans une gamme de taille de pores étendue.

Selon un deuxième exemple, illustré dans la figure 1B, des ions sont implantés à une profondeur P1 dans la couche 10, comme représenté par les flèches, ces ions étant de nature chimique différente par rapport à la nature chimique des ions implantés dans le premier exemple. Les pores 110 selon cet exemple ont un diamètre supérieur à celui des pores 110 formés dans le premier exemple. À titre d'exemple, pour une dose donnée, l'implantation d'ions de néon, avec certains paramètres d'implantation d'ions, peuvent permettre de former des pores de diamètre supérieur à celui de pores formés par l'implantation d'ions d'hydrogène à la même dose.

Notons que dans les deux exemples précédemment décrits, les profondeurs P1 peuvent varier d'un exemple à un autre, et par exemple selon l'énergie d'implantation utilisée.

Les pores dans la couche de silicium poreux 11' forment des sites de piégeage, par exemple pour des atomes métalliques présents dans la couche superficielle 10. D'autres ions peuvent par ailleurs être introduits par exemple par implantation, de manière à être piégés dans les pores. Du carbone peut par ailleurs être implanté avant ou après des ions susceptibles de former des pores dans la portion enterrée 11.

En outre, le procédé peut comprendre plusieurs implantations d'ions, de préférence successives. Ces implantations d'ions peuvent être configurées de façon à former des microstructures en plusieurs sous-portions enterrées 11a, 11b dans la couche 10. Ces sous-portions enterrées 11a, 11b peuvent notamment être formées à plusieurs profondeurs P1, P1' de la couche 10. De préférence, les implantations d'ions sont configurées de sorte que les sous-portions enterrées 11a, 11b soient juxtaposées selon une direction perpendiculaire à la surface 100 de la couche superficielle 10 du substrat support 1. Ces implantations d'ions peuvent en outre être configurées de sorte que les microstructures 110a, 110b soient différentes entre les sous-portions enterrées 11a, 11b. De façon synergique, l'implantation de différents ions ou de différents mélanges d'ions, à des profondeurs différentes dans la couche superficielle 10, permet de notamment former une couche de silicium poreux 11' présentant des porosités différentes, voire un gradient de porosité, selon une direction perpendiculaire à la direction d'extension principale de la couche de silicium poreux 11'.

À titre d'exemple, une première implantation d'ions peut être effectuée. Comme illustré en figure 1C, une microstructure 110a peut être obtenue dans une sous-portion enterrée 11a, à une profondeur P₁ de la couche 10. À la suite de cette première implantation, une deuxième implantation d'ions peut être effectuée, avec des paramètres d'implantation différents, de façon à obtenir une microstructure différente 110b, dans une sous-portion enterrée 11b à une profondeur P₂ de la couche 10, et juxtaposée à la sous-portion 11a. Selon cet exemple, le diamètre ou bien la densité volumique des pores 110b peut plus particulièrement être supérieur au diamètre des pores 110a ou inversement.

Le procédé peut ensuite comprendre un recuit thermique du substrat support 1. Ce recuit thermique peut être configuré pour former la microstructure de pores à partie de la couche enrichie en gaz, ou modifier la microstructure de pores 100 préalablement formée. Pour cela, le recuit thermique peut être réalisé à une température supérieure à au moins une température de l'implantation d'ions. À titre d'exemple, le diamètre de pores formés suite à une implantation d'ions de néon et suite à un recuit thermique à 1100°C, peut augmenter par rapport à leur diamètre avant recuit, comme décrit dans le document Caracterização da implantação de Ne em Si (100), Suzana Bottega Peripolli, Université Fédérale de Rio Grande do Sul, 2007.

Selon un exemple, une l'implantation d'ions d'hélium à une dose de 9.10¹⁵ ions/cm² à une énergie d'implantation de 40 keV à température ambiante suivie d'un recuit thermique formera une microstructure diluée de grands pores en forme de plaques. Selon un autre exemple, la même implantation effectuée à 350°C suivie d'un recuit thermique formera une microstructure de petits pores, notamment sphériques.

En outre, ce recuit peut être configuré pour évacuer le gaz de bulles 110 dans la portion enterrée 11, pour obtenir des cavités 110. Ce recuit peut dès lors être désigné recuit d'exodiffusion. Le gaz est ainsi évacué par effusion de la microstructure, c'est-à-dire que les molécules de gaz diffusent à travers la couche superficielle 10. Le risque de dégradation de l'état de la surface 100 de la couche superficielle 10 lors de l'oxydation thermique est ainsi minimisé, voire évité. En effet, si l'oxydation thermique est effectuée après l'implantation d'ion dans la portion enterrée 11, sans ce recuit thermique, il existe un risque que le gaz des bulles 110 induisent une déformation de la surface exposée 100, voire que le gaz s'échappe de façon explosive vers la surface 100. Ceci peut induire une augmentation de la rugosité de la surface 100.

Selon un exemple, le recuit est configuré de façon à éviter la formation d'un réseau de pores à partir de la microstructure 110. De préférence, les pores peuvent être isolés les uns des autres, pour augmenter la surface des pores dans la couche poreuse 11'. Selon un exemple alternatif, les pores peuvent être interconnectés les uns aux autres.

De préférence, la température du recuit thermique est comprise entre 150°C et 1100°C.

En outre, le recuit peut être un recuit par laser. Lors d'un recuit par laser, la température du recuit peut s'élever jusqu'à la température de fusion de la couche superficielle 10. En particulier, un recuit par laser, la longueur d'onde du laser étant choisie de façon à ne pas être absorbée de manière significative par la couche d'oxyde 12' de silicium. Par exemple, on pourra choisir une longueur d'onde dans les ultra-violets, et plus particulièrement une longueur d'onde de 308 nm. Le laser peut être un laser pulsé, c'est-à-dire que la surface 100 de la couche superficielle 10 est soumise à un rayonnement laser de façon intermittente par au moins une impulsion laser. L'impulsion peut être d'une durée allant de la nanoseconde à la microseconde.

Le procédé pouvant comprendre plusieurs implantations d'ions, le procédé peut comprendre un recuit thermique, effectué entre ou à la suite des implantations d'ions. Le procédé peut comprendre plusieurs recuits thermiques, par exemple à la suite de chacune des implantations d'ions. Par exemple, plusieurs implantations d'un même ion ou mélange d'ions et à la même profondeur P1, suivi chacune d'un recuit d'exodiffusion, peuvent être effectuées, de façon à augmenter la dose implantée dans la portion enterrée 11 en limitant la pression de gaz dans la portion 11 enterrée et ainsi le risque de dégradation de la surface exposée 100. Selon un autre exemple, on peut prévoir que plusieurs implantations d'un même ion ou mélange d'ions soit réalisées à des profondeurs différentes, et potentiellement suivi chacune d'un recuit d'exodiffusion.

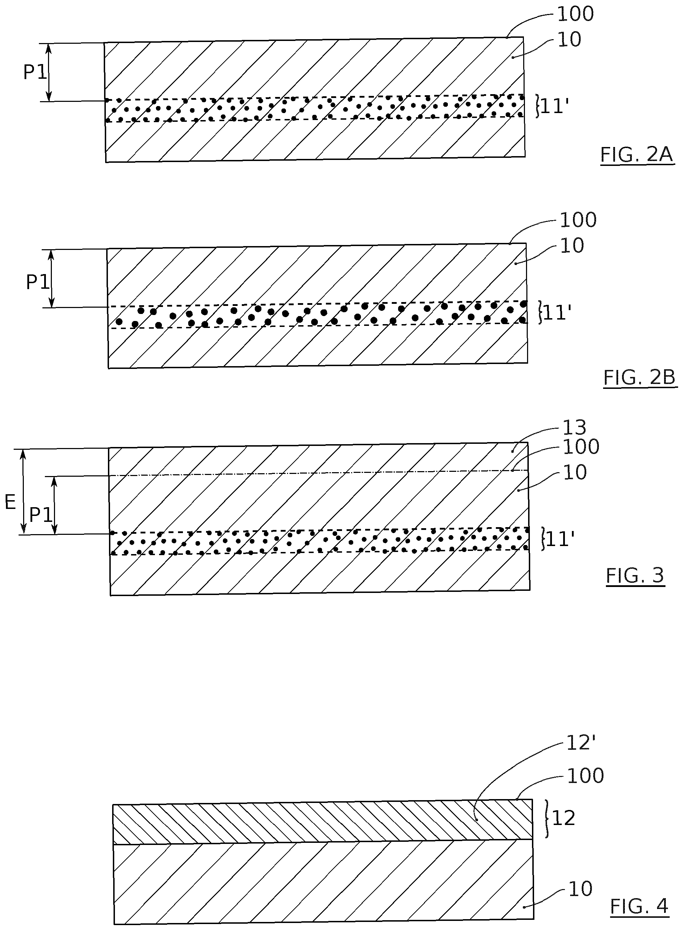

Le procédé peut en outre comprendre une croissance épitaxiale de silicium à la surface 100 de la couche superficielle 10 à base de silicium, de façon à augmenter l'épaisseur E de la couche superficielle 10 du substrat support 1, comme illustré sur la figure 3. Plus particulièrement, cette croissance épitaxiale peut être effectuée par épitaxie par jet moléculaire ou par épitaxie en phase vapeur. L'épaisseur de la couche épitaxiale 13 de silicium est de préférence inférieure à 2 µm. On peut alors considérer que la surface de la couche épitaxiale 13 de silicium forme une nouvelle surface 100 de la couche superficielle 10.

Le procédé comprend en outre l'oxydation thermique d'une portion superficielle 12 de la couche superficielle 10 pour former une couche d'oxyde 12' s'étendant à partir de la surface 100 de la couche superficielle 10. De préférence, la couche d'oxyde 12' formée s'étend sensiblement dans tout le plan principal d'extension de la couche superficielle 10. Plus préférentiellement, la couche d'oxyde 12' s'étend sensiblement dans tout le plan principal d'extension de la couche 10, de façon ininterrompue. L'oxydation et l'implantation d'ions sont en outre configurées de sorte que la couche d'oxyde 12' et la couche de silicium poreux 11' soient juxtaposées. Il y a donc une interface de juxtaposition entre ces deux couches, qui sont en contact. L'ordre relatif ainsi que les paramètres de l'une et /ou l'autre de l'implantation d'ions et de l'oxydation peuvent être ajustés pour cela. Comme énoncé précédemment, cette interface est d'une épaisseur inférieure à sensiblement 3 nm.

Dans le cas où l'implantation a lieu avant l'oxydation thermique, il est envisageable que lors de l'oxydation thermique, une partie, c'est-à-dire une épaisseur, de la couche poreuse 11', soit oxydée. Plus précisément, c'est le semi-conducteur constituant la partie solide de la couche poreuse qui est oxydé. Si le semi-conducteur est du Silicium, l'oxyde est du SiO₂. Selon cet exemple, l'interface de juxtaposition peut présenter une épaisseur sensiblement comprise entre 3 nm et 100 nm.

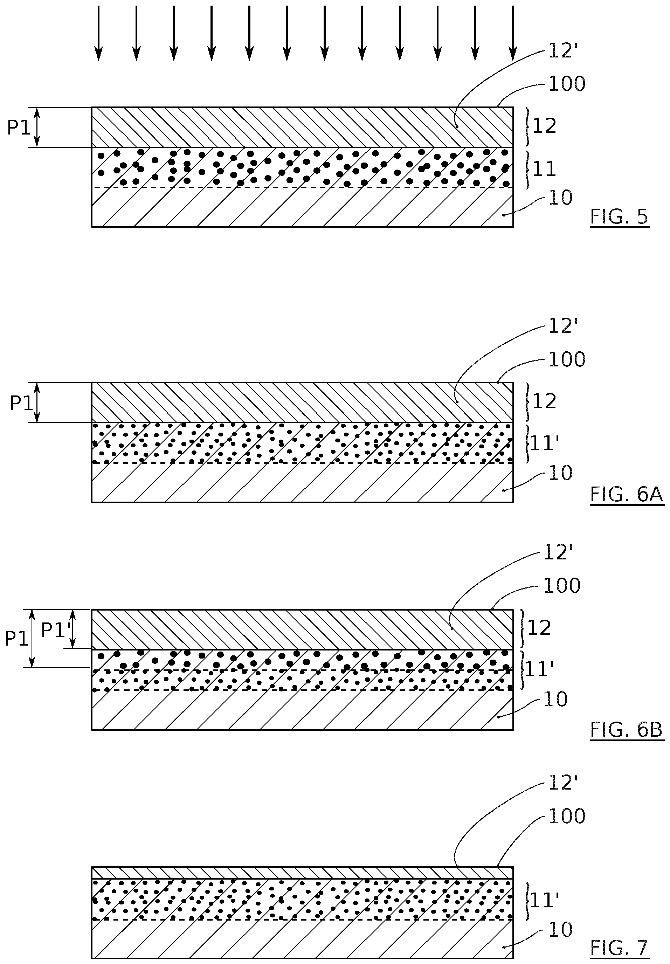

Selon une variante de réalisation, le procédé ne comprend pas d'oxydation thermique de la couche superficielle 10 du support 1. Selon cette variante, un empilement 2, décrit ultérieurement, comprend une couche d'oxyde, la couche d'oxyde étant destinée à être directement collée à la surface 100 de la couche 10.Selon un mode de réalisation, l'oxydation thermique peut être effectuée sur le substrat support 1 préalablement à l'implantation d'ions. Ce mode de réalisation est décrit en référence aux figures 4 et 5. Le substrat support 1 peut être exposé à un oxydant, lors d'un recuit à haute température, de façon à oxyder le silicium d'une portion superficielle 12 de la couche superficielle 10, pour former une couche d'oxyde de silicium 12'. Généralement, la température d'une oxydation thermique est comprise entre 800°C et 1200°C. Au moins l'une parmi la température la durée de l'oxydation thermique peut être adaptée de façon à moduler l'épaisseur de la couche d'oxyde 12' formée. Par exemple, plus la température est haute et/ou plus la durée de l'oxydation thermique est longue, plus l'épaisseur de la couche d'oxyde 12' sera grande. L'épaisseur de la couche d'oxyde 12' peut être comprise entre 20 nm et 400 nm. L'implantation d'ion peut ensuite être effectuée sur le substrat support 1, selon les caractéristiques précédemment décrites. Pour ce mode de réalisation, les paramètres de l'implantation d'ions seront choisis de sorte que la portion enterrée 11 soit juxtaposée à la couche d'oxyde 12' formée, comme illustrée par la figure 5. Ainsi, on évite que la microstructure de la couche de silicium poreux soit modifiée lors de l'oxydation thermique.

Selon un autre mode de réalisation, décrit en référence aux figures 6A et 6B, l'implantation d'ions peut être effectuée sur le substrat support 1, selon les caractéristiques précédemment décrites. L'oxydation thermique peut ensuite être configurée de façon à oxyder la portion superficielle 12 de la couche 10, cette portion s'étendant de la surface 100 de la couche superficielle 10 à la portion enterrée 11. Pour cela, comme précédemment, au moins l'une parmi la température et la durée de l'oxydation thermique peut être adaptée de façon à moduler l'épaisseur de la couche d'oxyde 12'. Ainsi, on évite que la couche d'oxyde 12' perturbe l'implantation des ions dans la portion enterrée 11 de la couche superficielle 10 du substrat support 1. L'implantation des ions à une profondeur importante du substrat support est alors facilitée. Une couche d'oxyde enterrée plus épaisse que dans l'état de la technique peut donc être obtenue.

Lorsque le procédé comprend une implantation d'ions et une croissance épitaxiale de silicium, suivies par l'oxydation thermique, l'épaisseur de la portion 12' peut être supérieure à 400 nm, par exemple jusqu'à 2 µm. On comprend alors que la croissance épitaxiale de silicium permet d'augmenter encore l'épaisseur de la couche d'oxyde 12'.

En outre, en effectuant l'oxydation thermique après l'implantation d'ions, le risque d'une éventuelle détérioration de la couche d'oxyde 12' par l'implantation d'ions dans la portion enterrée 11, est minimisé, voire évité. Ce mode de réalisation est ainsi particulièrement adapté pour des applications où une haute qualité de la couche d'oxyde enterrée est préférée. Selon un mode de réalisation particulier, on peut prévoir de réaliser une première implantation avant l'oxydation et une implantation complémentaire après l'oxydation pour réduire les dommages dans l'oxyde.

Selon l'un ou l'autre des modes de réalisation décrit, la couche superficielle 10 comprend une couche de silicium poreux 11', cette couche pouvant comprendre une pluralité de sous-couches, et une couche d'oxyde 12' juxtaposée, la couche d'oxyde 12' s'étendant jusqu'à la surface 100 de la couche superficielle 10. La rugosité de la couche d'oxyde 12' peut être de l'ordre de 5 Â.

Selon un mode de réalisation particulier, la couche d'oxyde 12' est une couche d'une épaisseur inférieure à l'épaisseur de la couche d'oxyde enterrée obtenue lors de l'assemblage ultérieur du substrat support 1 et du substrat donneur 2 pour former l'empilement multicouches de type SOI. Dans ce cas, l'épaisseur de la couche d'oxyde enterrée de l'empilement multicouche peut notamment être augmentée par le substrat donneur 2, cet exemple étant décrit de façon plus détaillée dans la suite. La couche d'oxyde enterrée de l'empilement multicouche peut ainsi être fournie majoritairement par le substrat donneur 2. Le procédé peut pour cela comprendre une gravure de la couche d'oxyde 12'. Le recours à la gravure permet d'éviter d'avoir à implanter des ions dans une portion enterrée 11 proche de la surface 100 de la couche superficielle 10, ce qui pourrait détériorer l'état de cette surface 100. Il est en effet possible de réaliser l'implantation d'ions, à une profondeur garantissant l'intégrité de la surface 100 de la couche superficielle 10, et l'oxydation thermique, dans l'un ou l'autre des ordres relatifs décrits précédemment. Ensuite la couche d'oxyde 12' peut être gravée jusqu'à atteindre l'épaisseur voulue. De préférence, l'épaisseur de la couche d'oxyde 12' après gravure est sensiblement inférieure à 20 nm. Cette gravure peut être une gravure humide conventionnelle, en mettant en œuvre une solution d'acide fluorhydrique. Selon une variante de réalisation, il est possible de graver complètement la couche d'oxyde 12' afin d'exposer une couche de silicium monocristallin non oxydée en vue d'un collage avec un empilement 2. L'empilement 2, décrit ultérieurement, comprend alors une couche d'oxyde, la couche d'oxyde étant destinée à être directement collée à la surface 100 de la couche 10.

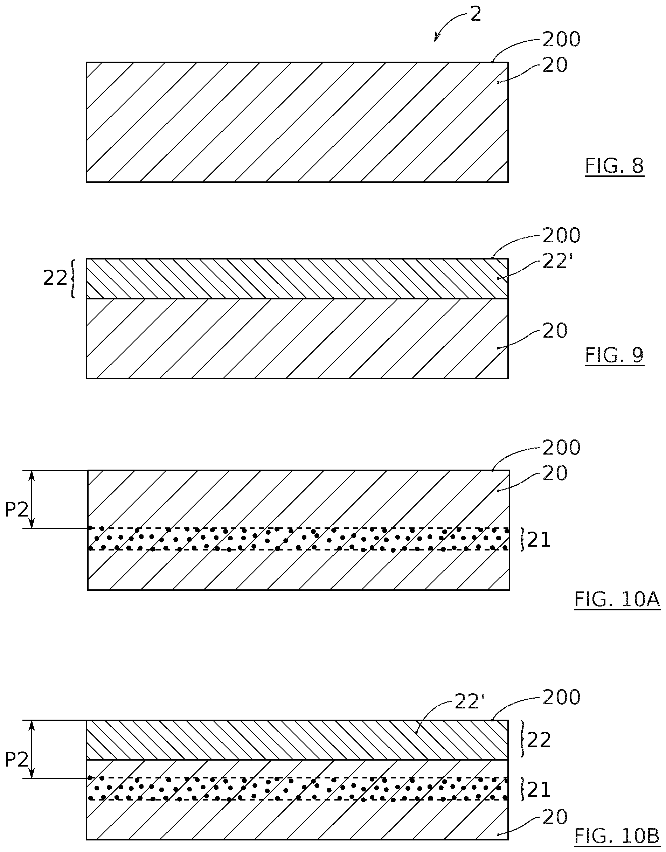

Selon un mode de réalisation de l'invention, les étapes du procédé relatives au substrat donneur sont maintenant décrites en référence aux figures 8 à 10B. Le procédé comprend tout d'abord la fourniture d'un substrat donneur 2, comme illustré en figure 8. Comme pour le substrat support 1, le substrat donneur 2 comprend une couche superficielle donneuse 20 à base d'un matériau semi-conducteur monocristallin. Notons que sur les figures 8 à 12B, seule la couche superficielle 20 du substrat donneur 2 est représentée. La couche 20, est donc située en surface du substrat donneur 2 et présente une surface exposée 200. Le substrat donneur 2 est à base d'un matériau semi-conducteur. À titre d'exemple, le matériau semi-conducteur peut être choisi parmi le silicium, ou des alliages de silicium semi-conducteurs tels que le carbure de silicium de formule SiC et un alliage de silicium-germanium de formule Si-Ge. Dans la suite, on se réfère au cas où le matériau semi-conducteur est à base de silicium. La couche superficielle donneuse 20 peut en outre être uniquement constituée de silicium, en négligeant les impuretés liées à la l'élaboration du silicium. Le substrat support 2 peut par exemple être un wafer de silicium.

Le procédé comprend la formation d'une zone de fragilisation 21 à une profondeur P2 non nulle de la surface 200 de la couche superficielle donneuse 20. De préférence, la zone de fragilisation 21 s'étend sensiblement dans tout le plan principal d'extension de la couche superficielle donneuse 20. Plus préférentiellement, la zone de fragilisation 21 s'étend sensiblement dans tout le plan principal d'extension de la couche 20 de façon ininterrompue.

Cette zone de fragilisation est par exemple formée par implantation d'ions, tels que des ions d'hydrogène ou d'hélium. Notons que toute autre technique de formation d'une zone de fragilisation, et notamment tout autre technique employée dans les procédés d'élaboration d'empilement de type SOI, peut être envisagée.

Le procédé peut en outre comprendre une oxydation, par exemple thermique, d'une portion superficielle 22 de la couche superficielle donneuse 20 pour former une couche d'oxyde 22' s'étendant à partir de la surface 200 de la couche superficielle donneuse 20. Cette couche d'oxyde 22' peut plus particulièrement être destinée à former la couche d'oxyde enterrée dans l'empilement de type SOI final. L'oxydation thermique est de préférence effectuée avant la formation de la zone de fragilisation 21, comme l'illustre le passage de la figure 9 à la figure 10B. Ainsi le risque d'une séparation de la zone de fragilisation 21 lors de l'oxydation est évité. La formation de la zone de fragilisation et l'oxydation thermique sont configurées de sorte que la distance entre la couche d'oxyde 22' et la zone de fragilisation 21 est non-nulle, selon une direction perpendiculaire à la direction d'extension principale de la couche d'oxyde 22' et de la zone de fragilisation 21.

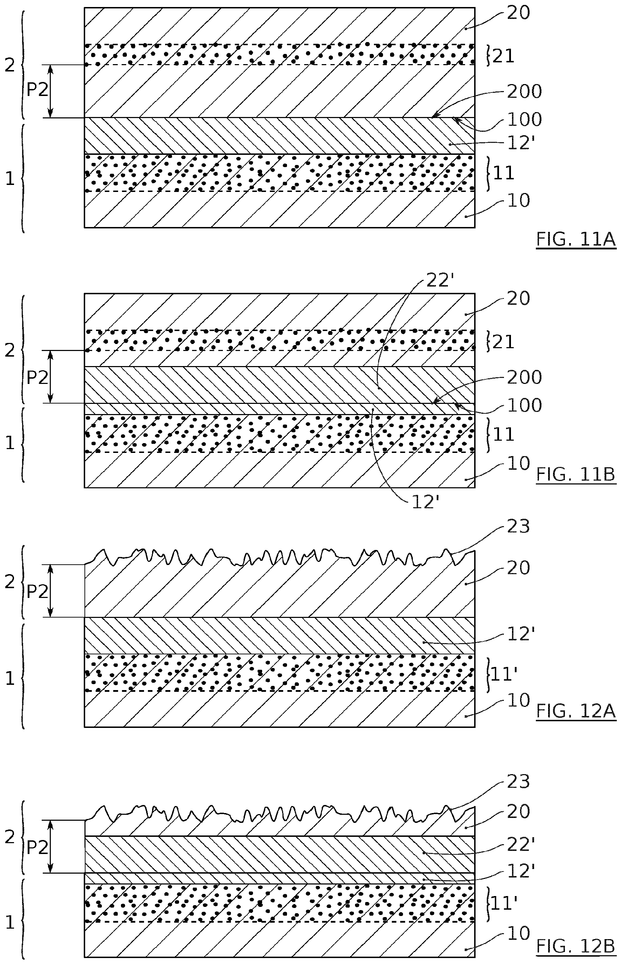

Suite aux étapes décrites précédemment, visant à préparer le substrat support 1 et le substrat donneur 2, le procédé comprend l'assemblage du substrat support 1 et du substrat donneur 2, de façon à les adjoindre. Cet assemblage est décrit en référence aux figures 11A et 11B. Cet assemblage est réalisé par la mise en contact de la surface 100 de la couche superficielle 10 du substrat support 1 à la surface 200 de la couche superficielle donneuse 20 du substrat donneur 2. Lorsque la couche d'oxyde 12' s'étend jusqu'à la surface 100, on comprend que la surface de la couche d'oxyde 12 forme la surface d'assemblage du substrat support 1. Les surfaces 100, 200 sont ensuite collées, et de préférence par collage direct.

De par les caractéristiques du procédé précédemment décrites, et notamment grâce au fait que la couche d'oxyde 12' soit formée par oxydation thermique, et que l'implantation d'ions et l'éventuel recuit thermique puisse être configurés de façon à garantir l'intégrité de la surface 100 de la couche superficielle 10 du substrat support 1, le procédé peut être exempt d'un polissage de la surface 100 de la couche superficielle 10, préalablement à l'assemblage. Le procédé peut en outre être exempt d'un polissage de la surface 200, de la couche superficielle donneuse 20, préalablement à l'assemblage. De préférence, le procédé est exempt d'un polissage de chacune des surfaces 100, 200. Le procédé permet d'obtenir un collage de qualité du substrat support 1 et du substrat donneur 2, de façon simplifiée et avec un coût limité.

Deux modes de réalisation particuliers sont maintenant décrits en référence aux figure 11A et 11B. Selon un premier exemple illustré en figure 11A, le substrat support 1 peut comprendre une couche superficielle 10, cette couche 10 comprenant une couche de silicium poreux 11', juxtaposée à une couche d'oxyde 12'. La couche d'oxyde 12' s'étend jusqu'à la surface 100 de la couche superficielle 10, et peut être d'une épaisseur comprise entre 5 nm et 2 µm. Le substrat donneur 2 comprend une couche superficielle 20, cette couche comprenant la zone de fragilisation 21 à une profondeur P2.

Selon un deuxième exemple illustré en figure 11B, le substrat support 1 peut comprendre une couche superficielle 10, cette couche 10 comprenant une couche de silicium poreux 11', juxtaposée à une couche d'oxyde 12'. La couche d'oxyde 12' s'étendant jusqu'à la surface 100 de la couche superficielle 10 et peut être d'une épaisseur inférieure à 20 nm. Le substrat donneur 2 comprend une couche superficielle 20, cette couche comprenant une couche d'oxyde 22' et une zone de fragilisation 21 à une profondeur P2, la couche superficielle donneuse 20 étant configurée de sorte la couche d'oxyde 22' et la zone de fragilisation 21 ne sont pas juxtaposées.

Suite à l'assemblage du substrat support 1 et du substrat donneur 2, le procédé comprend la séparation de la couche superficielle donneuse 20 du substrat donneur 2, au niveau de la zone de fragilisation 21, de façon à ce qu'une couche d'une épaisseur P2 de la couche superficielle donneuse 20 soit assemblées sur le substrat support 1, comme sur les exemples illustrés en figures 11A et 11B. Pour cela, la zone de fragilisation 21 forme une surface de séparation 23.

Suite à la séparation, la surface de séparation 23 peut être irrégulière. Un polissage ou lissage chimique et/ou mécanique et/ou thermique de la surface de séparation 23 peut être réalisé, de sorte que la surface de séparation 23 présente une rugosité adaptée pour d'autres procédés ultérieurs tels que des procédés d'élaboration de modules électroniques, et plus particulièrement de module RF-SOI. Le polissage de la surface de séparation 23 peut par exemple être illustré par le passage de la figure 12A à la figure 13A. Toute méthode de polissage mécano-chimique (CMP, abrégé de l'anglais *Chemical Mechanical Polishing*) ou thermique destinée à lisser une surface à base de silicium peut être envisagée. Par exemple, la surface de séparation 23 est oxydée pour l'amincir à une épaisseur souhaitée puis traitée par un recuit à haute température en présence d'hydrogène dans l'atmosphère du recuit.

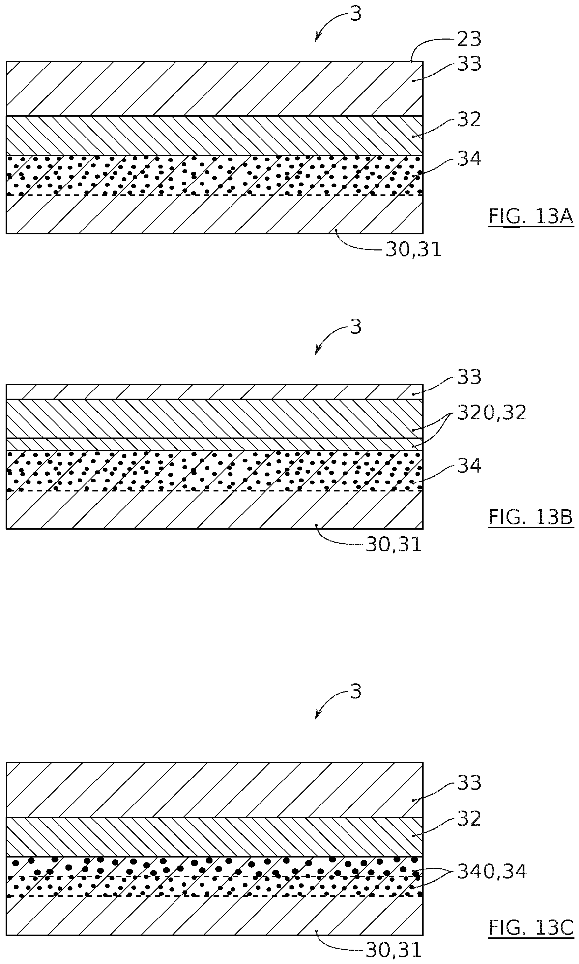

L'empilement multicouches 3 est maintenant décrit en référence aux figures 13A à 13C. L'empilement multicouches 3 peut plus particulièrement être obtenu par le procédé précédemment décrit.

L'empilement multicouches 3 comprend un substrat support 30 comprenant une première couche 31 à base de silicium monocristallin. Cette première couche 31 est juxtaposée à une couche de silicium poreux 34. L'empilement multicouches 3 comprend en outre une couche d'oxyde 32 de silicium enterrée disposée au contact entre la couche de silicium poreux 34 et une deuxième couche 33 à base de silicium monocristallin. La deuxième couche 33 peut être disposée en surface de l'empilement multicouches 3. Grâce à la juxtaposition directe d'une couche de silicium poreux 34 à la couche d'oxyde 32, les propriétés de l'empilement 3 sont améliorées, notamment pour des applications radiofréquences (RF). Par juxtaposition, il est entendu un recouvrement des différentes couches les unes au-dessus des autres selon une direction verticale, perpendiculaire à leur plan d'extension principale. En outre, la quantité de pièges dans la couche dépend de la surface des pores dans la couche. En variant la ou les microstructures de pores, les propriétés de piégeage de la couche poreuse peuvent être modulées.

Les caractéristiques précédemment décrites de la couche de silicium poreux 11', des couches d'oxydes 12', 22' peuvent s'appliquer à la couche de silicium poreux 34 et à la couche d'oxyde 32 de l'empilement multicouche.

Selon un exemple, la couche d'oxyde 32 peut par ailleurs comprendre plusieurs sous-couches 320, et plus particulièrement deux sous-couches 320, comme illustré dans la figure 13B. Selon un exemple alternatif ou complémentaire, la couche de silicium poreux 34 peut comprendre plusieurs sous-couches 340 juxtaposées. Au moins une parmi les sous-couches 340 peut présenter des pores de diamètre différent des diamètres des pores des autres sous-couches 340. De préférence, plusieurs sous-couches 340 forment une couche de silicium poreux 34 présentant un gradient de porosité selon une direction perpendiculaire à la direction d'extension principale de la couche de silicium poreux 34.

L'empilement multicouches 3 peut en outre être intégré dans un module RF-SOI.

Au vu de la description qui précède, il apparaît clairement que l'invention propose un procédé de fabrication d'un empilement multicouches de type SOI, et en particulier pour des technologies RF-SOI, dont les propriétés sont améliorées. Ce procédé permet en outre de faciliter la fabrication d'un substrat de type SOI, et en particulier pour des technologies RF-SOI.

L'invention n'est pas limitée aux modes de réalisations précédemment décrits et s'étend à tous les modes de réalisation couverts par les revendications.

On peut notamment prévoir que le procédé comprenne plusieurs implantations d'ions dans la couche superficielle 10 du substrat support 1 ; de façon non successive. Au moins une de ces implantations d'ions pourrait être effectuée avant l'oxydation thermique, et au moins une de ces implantations d'ions pourrait être effectuée après l'oxydation thermique.

On peut en outre prévoir qu'une implantation d'ion soit configurée de sorte qu'une couche de silicium poreux 11' soit formée, et non en contact avec la couche d'oxyde 12' ou à une autre couche de silicium poreux 11'. L'empilement multicouches 3 obtenu pourrait alors comprendre une deuxième couche de silicium poreux enterrée dans la couche à base de silicium monocristallin du substrat support, et non en contact avec la couche d'oxyde 32 ou à la première couche de silicium poreux 34.

On peut prévoir d'effectuer une pluralité de séquence d'oxydation, d'implantation d'ions, voire de recuit. On peut en outre prévoir d'assembler le substrat support sans gravure de la couche d'oxyde à un substrat donneur comprenant une couche d'oxyde, pour obtenir un oxyde plus épais.

### LISTE DES REFERENCES

- 1: Substrat support
- 10: Couche superficielle
- 100: Surface
- 11: Portion enterrée
- 11a: Sous-portion
- 11b: Sous-portion
- 110: Microstructure
- 110a: Première microstructure
- 110b: Deuxième microstructure
- 11': Couche de silicium poreux
- 12: Portion superficielle
- 12': Couche d'oxyde de silicium
- 13: Couche épitaxiale de silicium
- 2: Substrat donneur
- 20: Couche superficielle donneuse
- 21: Zone de fragilisation
- 22: Portion superficielle
- 22': Couche d'oxyde de silicium
- 23: Surface séparée
- 3: Empilement multicouche
- 30: Substrat support
- 31: Première couche à base de silicium monocristallin
- 32: Couche d'oxyde de silicium
- 320: Sous-couche
- 33: Deuxième couche à base de silicium monocristallin
- 34: Couche de silicium poreux
- 340: Sous-couche
- E: Épaisseur de la couche superficielle du substrat donneur
- P1: Profondeur de la surface de la couche superficielle du substrat support
- P1': Deuxième profondeur de la surface de la couche superficielle du substrat support
- P2: Profondeur de la surface de la couche superficielle donneuse du substrat donneur

## Revendications

1. Procédé d'élaboration d'un empilement multicouche (3) de type semi-conducteur-sur-isolant, le procédé comprenant :
- une fourniture d'un substrat support (1), le substrat support (1) comprenant une couche superficielle (10) à base d'un matériau semi-conducteur monocristallin, puis
- une implantation d'ions choisis parmi des ions de gaz noble et d'hydrogène dans une portion enterrée (11) de la couche superficielle (10) du substrat support (1), à une profondeur (P1) de la surface (100) de la couche superficielle (10), de façon à former une couche enrichie en au moins un gaz, formée à partir desdits ions, dans ladite portion enterrée (11), ladite couche enrichie en au moins un gaz étant destinée à former une couche de matériau semi-conducteur poreux (11'),
- une oxydation thermique d'une portion au moins superficielle (12) de la couche superficielle (10), pour former une couche d'oxyde (12') s'étendant à partir de la surface (100) de la couche superficielle (10) du substrat support (1), l'oxydation et l'implantation d'ions étant configurées de sorte que la couche d'oxyde (12') et la couche enrichie en au moins un gaz soient juxtaposées,
- une fourniture d'un substrat donneur (2), le substrat donneur (2) comprenant une couche superficielle donneuse (20), présentant une surface (200),
- un assemblage du substrat support (1) et du substrat donneur (2),
**caractérisé en ce que** l'implantation d'ions dans la portion enterrée (11) de la couche superficielle (10) du substrat support (1), précède l'oxydation thermique de la portion superficielle (12) de la couche superficielle (10) du substrat support (1).

2. Procédé selon la revendication précédente, le procédé étant exempt d'un polissage de la surface (100, 200) d'au moins l'une parmi la couche superficielle (10) du substrat support (1) et la couche superficielle donneuse (20) du substrat donneur (2), préalablement à l'assemblage du substrat support (1) et du substrat donneur (2).

3. Procédé selon l'une quelconque des revendications précédentes, le procédé comprenant en outre, entre l'implantation d'ions dans la portion enterrée (11) de la couche superficielle (10) du substrat support (1) et l'oxydation thermique de la portion superficielle (12) de la couche superficielle (10) du substrat support (1), une croissance épitaxiale d'une couche de matériau semi-conducteur (13) sur la surface (100) de la couche superficielle (10) du substrat support (1).

4. Procédé selon l'une quelconque des revendications précédentes, le procédé comprenant en outre un recuit thermique du substrat support (1) à la suite de l'implantation d'ions dans la portion enterrée (11) de la couche superficielle (10) du substrat support (1).

5. Procédé selon la revendication précédente, dans lequel le recuit thermique comprend un recuit d'exodiffusion pour évacuer l'au moins un gaz de ladite couche enrichie.

6. Procédé selon l'une quelconque des revendications précédentes, dans lequel, l'implantation d'ions dans la portion enterrée (11) de la couche superficielle (10) du substrat support (1) est effectuée à une énergie d'implantation comprise entre 0,5 keV et 1 MeV, de préférence entre 1 et 200 keV.

7. Procédé selon l'une quelconque des revendications précédentes, dans lequel, le procédé comprend plusieurs implantations d'ions, de préférence successives.

8. Procédé selon la revendication précédente, dans lequel les éléments chimiques des ions et/ou les proportions relatives entre des ions d'éléments chimiques distincts varient entre les différentes implantations d'ions.

9. Procédé selon l'une quelconque des revendications 7 et 8, dans lequel au moins une parmi les plusieurs implantations d'ions est réalisée à une profondeur d'implantation différente par rapport aux profondeurs d'implantation des autres implantations d'ions.

10. Procédé selon l'une quelconque des revendications 7 à 9, dans lequel au moins une parmi les plusieurs implantations d'ions est configurée pour implanter une dose différente par rapport aux doses implantées des autres implantations d'ions.

11. Procédé selon l'une quelconque des revendications précédentes, dans lequel l'oxydation thermique formant la couche d'oxyde (12') forme une interface de juxtaposition avec la couche enrichie en au moins un gaz, dans laquelle au moins une partie de la couche enrichie en au moins un gaz est oxydée.

12. Procédé selon la revendication précédente dans lequel l'interface de juxtaposition présente une épaisseur comprise entre 3 nm et 100 nm.

13. Procédé d'élaboration d'un empilement multicouche (3) de type semi-conducteur-sur-isolant, le procédé comprenant :
- une fourniture d'un substrat support (1), le substrat support (1) comprenant une couche superficielle (10) à base d'un matériau semi-conducteur monocristallin, puis
- une implantation d'ions choisis parmi des ions de gaz noble et d'hydrogène dans une portion enterrée (11) de la couche superficielle (10) du substrat support (1), à une profondeur (P1) de la surface (100) de la couche superficielle (10), de façon à former une couche enrichie en au moins un gaz, formée à partir desdits ions, dans ladite portion enterrée (11), ladite couche enrichie en au moins un gaz étant destinée à former une couche de matériau semi-conducteur poreux (11'),
- une fourniture d'un substrat donneur (2), le substrat donneur (2) comprenant une couche superficielle donneuse (20), comprenant une couche d'oxyde (22'),
- après l'implantation, un assemblage du substrat support (1) et du substrat donneur (2), le procédé étant configuré de sorte que la couche d'oxyde du substrat donneur et la couche enrichie en au moins un gaz soient juxtaposées.
